# EUROPÄISCHE PATENTANMELDUNG

(11) **EP 4 056 740 A1**
(43) Veröffentlichungstag der Anmeldung: **14.09.2022**
(21) Anmeldenummer: 21161684.2
(22) Anmeldetag: 10.03.2021
(51) Int. Cl.: C30B 25/08, C30B 29/06, C23C 16/44, C23C 16/24, C30B 25/20

(54) **VERFAHREN ZUM HERSTELLEN VON HALBLEITERSCHEIBEN MIT EPITAKTISCHER SCHICHT IN EINER KAMMER EINES ABSCHEIDEREAKTORS**

(71) Anmelder: Siltronic AG, 81677 München (DE)
(72) Erfinder: Edmaier, Walter, 84384 Wittibreut (DE); Hecht, Hannes, 84489 Burghausen (DE); Lauer, Michael, 84489 Burghausen (DE); Lichtenegger, Korbinian, 81669 München (DE)
(74) Vertreter: Staudacher, Wolfgang

(57) **Zusammenfassung**

Verfahren zum Herstellen von Halbleiterscheiben mit epitaktischer Schicht in einer Kammer eines Abscheidereaktors einer Anlage, umfassend
das wiederholte Abscheiden einer epitaktischen Schicht auf einer Substratscheibe in der Kammer des Abscheidereaktors, wobei eine erste Anzahl von Halbleiterscheiben mit epitaktischer Schicht entsteht, und währenddessen
das Konditionieren einer Ersatzkammer des Abscheidereaktors außerhalb der Anlage durch Spülen der Ersatzkammer mit einem Spülgas;
das Unterbrechen des wiederholten Abscheidens einer epitaktischen Schicht auf einer Substratscheibe;
das Ersetzen der Kammer durch die Ersatzkammer; und
das Fortsetzen des wiederholten Abscheidens einer epitaktischen Schicht auf einer Substratscheibe in der Ersatzkammer des Abscheidereaktors, wobei eine zweite Anzahl von Halbleiterscheiben mit epitaktischer Schicht entsteht.

## Beschreibung

Gegenstand der Erfindung ist ein Verfahren zum Herstellen von Halbleiterscheiben mit epitaktischer Schicht in einer Kammer eines Abscheidereaktors mittels Gasphasenabscheidung. Üblicherweise wird ein solches Verfahren von Zeit zu Zeit unterbrochen, um die Kammer zu warten, insbesondere, um Material zu beseitigen, das sich an inneren Wänden der Kammer niedergeschlagen hat. Danach befindet sich die Kammer in einem Zustand, der es noch nicht zulässt, darin Halbleiterscheiben zu beschichten, die den Erwartungen entsprechen, insbesondere in Bezug auf die geforderte Lebensdauer von Minoritätsladungsträgern in der epitaktischen Schicht. Es ist daher eine Konditionierung der Kammer notwendig, die die Produktivität des Verfahrens einschränkt.

### Stand der Technik / Probleme

US 2008 0 219 824 A1 beschreibt eine typische Anlage, mit der ein Verfahren zum Herstellen von Halbleiterscheiben mit epitaktischer Schicht mittels Gasphasenabscheidung durchgeführt werden kann. Eine solche Anlage umfasst in der Regel mehrere Abscheidereaktoren, eine Schleusenkammer (load lock chamber) und eine Transferkammer. Ein Abscheidereaktor umfasst insbesondere eine obere Abdeckung (upper dome), eine untere Abdeckung (lower dome), einen Grundring (base ring) sowie einen oberen und einen unteren Klemmring (upper and lower liner), die gemeinschaftlich zu einer Kammer gehören, in der die Gasphasenabscheidung stattfindet. In der Kammer befinden sich insbesondere eine Suszeptor-Tragwelle (susceptor support shaft) mit Tragarmen (support arms), eine Scheiben-Hebewelle (wafer lift shaft) und ein Suszeptor. Die Suszeptor-Tragwelle und die Scheiben-Hebewelle sind mit einer Rotations-Hub-Einheit verbunden. Über der oberen Abdeckung und unter der unteren Abdeckung sind Lampen-Module und Reflektoren angeordnet, um Strahlungsenergie in der Kammer während der Gasphasenabscheidung bereitstellen zu können.

In DE 11 2016 003 399 T5 wird angeregt die Kammer eines Abscheidereaktors zum Zweck des Konditionierens in der Anlage mit Stickstoff zu spülen, die Innenseite der Kammer zu erwärmen und mittels Messung der Lebensdauer von Minoritätsladungsträgern von Testscheiben zu entscheiden, ob die Produktion von Halbleiterscheiben mit epitaktischer Schicht fortgesetzt werden kann.

Eine derartig durchgeführte Konditionierung der Kammer schränkt die Produktivität der Herstellung von Halbleiterscheiben mit epitaktischer Schicht beachtlich ein.

Aufgabe der vorliegenden Erfindung ist es, eine solche Einschränkung zu verringern und eine besonders effektive Konditionierung vorzuschlagen.

Die Aufgabe der Erfindung wird gelöst durch ein Verfahren zum Herstellen von Halbleiterscheiben mit epitaktischer Schicht in einer Kammer eines Abscheidereaktors einer Anlage, umfassend
das wiederholte Abscheiden einer epitaktischen Schicht auf einer Substratscheibe in der Kammer des Abscheidereaktors, wobei eine erste Anzahl von Halbleiterscheiben mit epitaktischer Schicht entsteht, und währenddessen
das Konditionieren einer Ersatzkammer des Abscheidereaktors außerhalb der Anlage durch Spülen der Ersatzkammer mit einem Spülgas;
das Unterbrechen des wiederholten Abscheidens einer epitaktischen Schicht auf einer Substratscheibe;
das Ersetzen der Kammer durch die Ersatzkammer; und
das Fortsetzen des wiederholten Abscheidens einer epitaktischen Schicht auf einer Substratscheibe in der Ersatzkammer des Abscheidereaktors, wobei eine zweite Anzahl von Halbleiterscheiben mit epitaktischer Schicht entsteht.

Die Zeit eingeschränkter Produktivität wegen des Konditionierens der Kammer ist bei Anwendung des erfindungsgemäßen Verfahrens deutlich verkürzt und insbesondere der Dauer des Ersetzens der Kammer durch die Ersatzkammer geschuldet. Die durch die Ersatzkammer ersetzte Kammer wird nach dem Ersetzen selbst zu einer Ersatzkammer, die außerhalb der Anlage konditioniert werden kann. Die Anlage umfasst einen Abscheidereaktor, vorzugsweise mindestens einen weiteren Abscheidereaktor.

Eine Ersatzkammer umfasst als Bestandteile vorzugsweise eine obere Abdeckung, eine untere Abdeckung, einen Grundring, einen oberen und einen unteren Klemmring, eine Suszeptor-Tragwelle mit Tragarmen, eine Scheiben-Hebewelle, einen Suszeptor, ein unteres Lampenmodul mit unteren Reflektoren und eine Rotations-Hub-Einheit für die Wellen. Diese Bestandteile sind während des Konditionierens der Ersatzkammer auf dieselbe Weise zusammengebaut, wie während einer Gasphasenabscheidung. Ein oberes Lampenmodul mit oberen Reflektoren kann wahlweise ebenfalls Bestandteil der Ersatzkammer sein.

Das Konditionieren der Ersatzkammer wird außerhalb der Anlage auf einem Konditionierungsstand durchgeführt und umfasst das Spülen der Ersatzkammer mit einem Spülgas und vorzugsweise eine oder zwei weitere Maßnahmen. Das Spülgas wird von mindestens einem Gaseinlass zu mindestens einem Gasauslass durch die Ersatzkammer geleitet. Der Anteil an Wasser im Spülgas ist beim Eintritt des Spülgases in die Ersatzkammer vorzugsweise kleiner als 100 ppm, besonders bevorzugt kleiner als 50 ppm. Darüber hinaus ist das Spülgas vorzugsweise frei von Partikeln, insbesondere frei von metallischen Partikeln.

Das Spülgas ist Stickstoff, Wasserstoff, Helium, Argon oder eine Mischung von mindestens zwei der genannten Gase. Bevorzugt wird Stickstoff als Spülgas eingesetzt. Beim Spülen der Ersatzkammer sollte darauf geachtet werden, dass möglichst keine Totstellen im Inneren der Ersatzkammer vorhanden sind, an denen die Strömungsgeschwindigkeit des Spülgases derart abnimmt, dass sie verschwindet.

Zu den weiteren Maßnahmen gehört das Erhöhen der Temperatur im Inneren der Ersatzkammer im Vergleich zur Temperatur der Umgebung der Ersatzkammer, beispielsweise mittels IR-Strahlung, Wärmematten oder Wärmetauschern oder eine Kombination davon. Vorzugsweise beträgt die Temperatur an Stellen der Bestandteile der Ersatzkammer, wo Kontakt zum Innenraum der Ersatzkammer besteht, mehr als 21 °C, vorzugsweise mehr als 65 °C. Die Temperatur ist nach oben grundsätzlich nur begrenzt durch die Temperatur-Belastbarkeit des Materials, das erhitzt wird.

Zu den weiteren Maßnahmen gehört auch das Ändern des Drucks im Innenraum der Ersatzkammer während des Konditionierens, wobei die Druckänderung auf zwei verschiedene Arten durchgeführt werden kann. Entweder durch Absenken des Drucks im Innenraum der Ersatzkammer im Vergleich zum Druck auf dem Konditionierungsstand oder durch Erhöhen des Drucks im Innenraum der Ersatzkammer im Vergleich zum Druck auf dem Konditionierungsstand. Zum Absenken des Drucks können Ventile und/oder eine Vakuumpumpe am Gasauslass der Ersatzkammer eingesetzt werden.

Darüber hinaus kann auch eine Kombination der zwei Arten von Druckänderungen durchgeführt werden, beispielsweise indem erst der Druck an Spülgas im Innenraum der Ersatzkammer erhöht und anschließend mittels Absaugens des Spülgases am Gasauslass unter den Druck am Konditionierungsstand abgesenkt wird.

Das Konditionieren der Ersatzkammer wird während einer vorgegebenen Dauer durchgeführt oder vorzugsweise solange, bis der Anteil an Wasser im Spülgas beim Verlassen der Ersatzkammer einen vorgegebenen Schwellwert erreicht oder unterschritten hat. Zu diesem Zweck kann die Feuchtigkeit im Spülgas beispielsweise am Gasauslass der Ersatzkammer gemessen werden.

Nach dem Konditionieren kann die Ersatzkammer verschlossen werden, um zu verhindern, dass während des Transports zur Anlage Atmosphäre der Umgebung in den Innenraum der Ersatzkammer gelangt. Die Druckdifferenz zwischen dem Druck im Innenraum und dem Druck in der Umgebung der verschlossenen Ersatzkammer sollte während des Transports der Ersatzkammer zur Anlage möglichst gering sein, um ein mögliches Implodieren der Ersatzkammer zu vermeiden. Das Ersetzen der Kammer durch die konditionierte Ersatzkammer sollte dann unter einer Atmosphäre von trockenem Spülgas erfolgen, um zu vermeiden, dass beim Auswechseln der Kammern Feuchtigkeit in die Ersatzkammer gelangt.

Der Transport zur Anlage und das Ersetzen der Kammer kann alternativ auch unter fortgesetztem Spülen der Ersatzkammer mit trockenem Spülgas erfolgen, so dass kein Druckunterschied zwischen dem Innenraum und der Umgebung besteht. Eine Durchflussgeschwindigkeit von 3 NI/min bis 8 NI/min ist in diesem Fall empfehlenswert.

Die erfindungsgemäß hergestellten Halbleiterscheiben bestehen vorzugsweise aus Silizium oder umfassen Substratscheiben aus Silizium mit mindestens einer epitaktischen Schicht aus Siliziumgermanium oder mit mindestens einer epitaktischen Schicht aus Galliumnitrid. Der Durchmesser der Halbleiterscheiben beträgt vorzugsweise mindestens 200 mm, besonders bevorzugt 300 mm.

Die Erfindung wird nachfolgend unter Bezugnahme auf Zeichnungen weiter erläutert.

### Kurzbeschreibung der Figuren

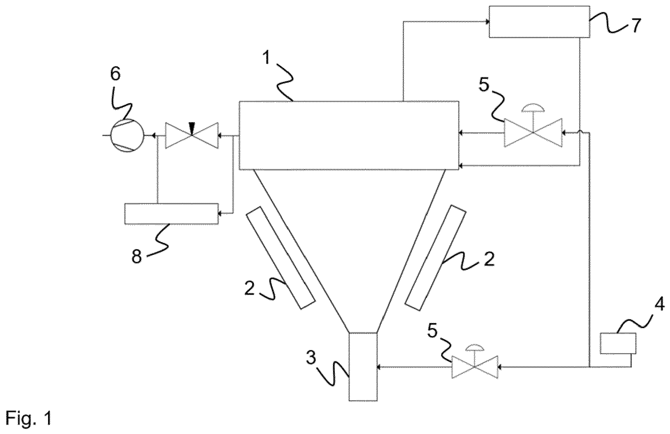

**Fig. 1** zeigt einen Ablaufplan für die Konditionierung einer Ersatzkammer auf einem Konditionierungsstand gemäß einer Ausführungsform der Erfindung.
**Fig. 2** zeigt das Ergebnis eines Vergleichs von Lebensdauermessungen an Halbleiterscheiben mit epitaktischer Schicht.

### Liste der verwendeten Bezugszeichen

- **1**: Ersatzkammer
- **2**: Lampenmodul
- **3**: Rotations-Hub-Einheit
- **4**: Gasversorgung
- **5**: Ventil
- **6**: Pumpe
- **7**: Heizung
- **8**: Mess-Apparatur

### Detaillierte Beschreibung erfindungsgemäßer Ausführungsbeispiele

Die Ersatzkammer 1 umfasst als Bestandteile eine obere Abdeckung, eine untere Abdeckung, einen Grundring, einen oberen und einen unteren Klemmring, eine Suszeptor-Tragwelle mit Tragarmen, eine Scheiben-Hebewelle und einen Suszeptor. Weitere Bestandteile sind ein unteres Lampenmodul 2 mit unteren Reflektoren und eine Rotations-Hub-Einheit 3 für die Wellen. Mittels einer Gasversorgung 4 wird trockenes Spülgas durch die Ersatzkammer 1 geleitet, wobei die Menge an Gasstrom durch Ventile 5 am Gaseinlass und die Leistung einer Pumpe 6 am Gasauslass eingestellt wird. Darüber hinaus sieht der Ablaufplan vor, die Temperatur im Innenraum der Ersatzkammer 1 mittels einer Heizung 7 zu erhöhen und die Feuchtigkeit des Spülgases nach dem Verlassen der Ersatzkammer 1 mittels einer Mess-Apparatur 8 zu ermitteln.

Auf Substratscheiben aus einkristallinem Silizium wurde eine epitaktische Schicht aus Silizium abgeschieden. Nachdem jeweils eine erste Anzahl von Halbleiterscheiben mit epitaktischer Schicht hergestellt worden war, wurde im Fall eines Vergleichsbeispiels die Kammer im Abscheidereaktor durch eine andere Kammer ersetzt und die andere Kammer im Abscheidereaktor durch Spülen mit Spülgas konditioniert, im Fall eines Beispiels wurde eine Ersatzkammer entsprechend der vorliegenden Erfindung konditioniert. Danach wurde jeweils eine zweite Anzahl von Halbeiterscheiben mit epitaktischer Schicht hergestellt, die Halbleiterscheiben gemäß Vergleichsbeispiel in der anderen Kammer, die Halbleiterscheiben gemäß Beispiel in der Ersatzkammer. Anschließend wurden Lebensdauermessungen von Minoritätsladungsträgern an den Halbleiterscheiben, die nach dem Konditionieren hergestellt worden waren, mittels µ-PCD (micro wave photoconductivity decay, a.u. = arbitrary units) vorgenommen.

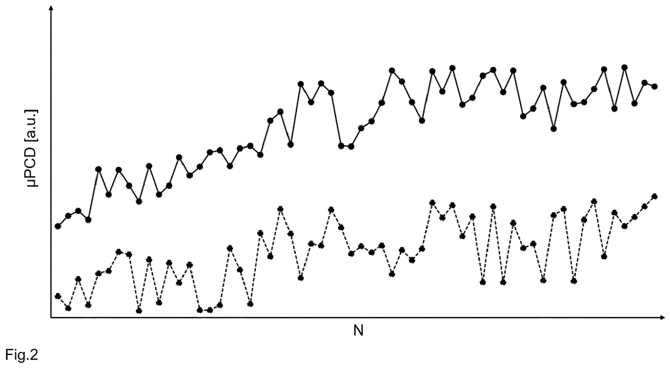

Fig. 2 zeigt das Ergebnis der Messungen für jeweils eine Anzahl N der Halbleiterscheiben gemäß Vergleichsbeispiel (gestrichelte Kurve) und gemäß Beispiel (durchgezogene Kurve). Die Werte für die Lebensdauer waren bei den erfindungsgemäß hergestellten Halbleiterscheiben von Anfang an höher und zeigten sofort eine ansteigende Tendenz.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Verfahren zum Herstellen von Halbleiterscheiben mit epitaktischer Schicht in einer Kammer eines Abscheidereaktors einer Anlage, umfassend
das wiederholte Abscheiden einer epitaktischen Schicht auf einer Substratscheibe in der Kammer des Abscheidereaktors, wobei eine erste Anzahl von Halbleiterscheiben mit epitaktischer Schicht entsteht, und währenddessen
das Konditionieren einer Ersatzkammer des Abscheidereaktors außerhalb der Anlage durch Spülen der Ersatzkammer mit einem Spülgas;
das Unterbrechen des wiederholten Abscheidens einer epitaktischen Schicht auf einer Substratscheibe;
das Ersetzen der Kammer durch die Ersatzkammer; und
das Fortsetzen des wiederholten Abscheidens einer epitaktischen Schicht auf einer Substratscheibe in der Ersatzkammer des Abscheidereaktors, wobei eine zweite Anzahl von Halbleiterscheiben mit epitaktischer Schicht entsteht.

2. Verfahren nach Anspruch 1, **dadurch gekennzeichnet, dass** das Spülgas durch die Ersatzkammer geleitet wird, und ein Anteil an Wasser im Spülgas beim Eintritt in die Ersatzkammer kleiner als 50 ppm ist.

3. Verfahren nach Anspruch 1 oder Anspruch 2, **dadurch gekennzeichnet, dass** als Spülgas Stickstoff, Wasserstoff, Helium, Argon oder eine Mischung von mindestens zwei der genannten Gase verwendet wird.

4. Verfahren nach einem der Ansprüche 1 bis 3, **dadurch gekennzeichnet, dass** während des Konditionierens der Ersatzkammer die Temperatur im Inneren der Ersatzkammer im Vergleich zur Temperatur der Umgebung der Ersatzkammer erhöht wird.

5. Verfahren nach einem der Ansprüche 1 bis 4, **dadurch gekennzeichnet, dass** während des Konditionierens der Ersatzkammer der Druck im Inneren der Ersatzkammer in Vergleich zum Druck in der Umgebung der Ersatzkammer mindestens einmal geändert wird.

6. Verfahren nach einem der Ansprüche 1 bis 5, **dadurch gekennzeichnet, dass** eine Feuchtigkeit des Spülgases nach dem Verlassen der Ersatzkammer gemessen wird und das Konditionieren der Ersatzkammer fortgesetzt wird, solange die Feuchtigkeit einen vorgegebenen Schwellwert noch nicht erreicht oder unterschritten hat.

7. Verfahren nach einem der Ansprüche 1 bis 6, **dadurch gekennzeichnet, dass** die Ersatzkammer nach dem Konditionieren verschlossen und in geschlossenem Zustand zur Anlage transportiert wird.

8. Verfahren nach einem der Ansprüche 1 bis 6, **dadurch gekennzeichnet, dass** die Ersatzkammer nach dem Konditionieren zur Anlage transportiert und dabei Spülgas durch die Ersatzkammer geleitet wird.
